Europäisches Patentamt

European Patent Office

Office européen des brevets

(19)

(11) Publication number: **0 137 918**
**B1**

(12)

# EUROPEAN PATENT SPECIFICATION

(45) Date of publication of patent specification: **11.01.89**

(51) Int. Cl.⁴: **H 01 L 21/31**

(21) Application number: **84107995.7**

(22) Date of filing: **07.07.84**

(54) **Method for eliminating edge lift up during thermal oxidation of a polycrystalline silicon member.**

(30) Priority: **25.07.83 US 516610**

(43) Date of publication of application:
**24.04.85 Bulletin 85/17**

(45) Publication of the grant of the patent:
**11.01.89 Bulletin 89/02**

(84) Designated Contracting States:
**DE FR NL**

(56) References cited:
**DE-A-2 916 098**

**IBM TECHNICAL DISCLOSURE BULLETIN, vol.
24, no. 7A, December 1981, New York, USA; G.
DOMENICUCCI et al. "Sidewall passivation and
insulation using a silicon dioxide-silicon nitride
barrier", page 3431**

(73) Proprietor: **GENERAL ELECTRIC COMPANY
1 River Road
Schenectady New York 12305 (US)**

(72) Inventor: **Ghezzo, Mario
79 Blue Spruce Lane
Ballston Lake New York 12019 (US)**
Inventor: **Parks, Harold George
12 Sandalwood Lane
Scocia New York 12302 (US)**

(74) Representative: **Sieb, Rolf, Dr. et al
General Electric - Deutschland Patentabteilung
Praunheimer Landstrasse 50
D-6000 Frankfurt/Main (DE)**

Courier Press, Leamington Spa, England.

# Description

The present invention relates to a method for producing a thermal oxide coating on a member of polycrystalline silicon on an insulating substrate without resultant lift up of the edges of the polycrystalline silicon member.

Patterned lines of polycrystalline silicon on an insulating substrate are used in integrated circuit devices as the gates of the MOS (Metal-Oxide-Semiconductor) transistors and as conductive lines. When such lines of polycrystalline silicon are subsequently thermally oxidized to provide electrical isolation of the lines from other members of an integrated circuit, the oxidation of the polycrystalline silicon member proceeds at a more rapid rate at the interface between the polycrystalline silicon member and the insulating substrate, thereby producing a lift-up of the member of polycrystalline silicon at the edges thereof and forming a reentrant profile in the resultant silicon dioxide coating. Such a reentrant profile makes it difficult to provide continuity in conductive lines extending over the reentrant profile of silicon dioxide. When members of polycrystalline silicon so formed are used as gates in MOS transistors, lift up of the edges of the polycrystalline silicon semiconductor member causes a shift in gate threshold voltage due to variations in gate oxide thickness. This problem is particularly acute in devices of small dimensions.

It is an object of the present invention to provide a thermal oxide on members of polycrystalline silicon on insulated substrates without causing lift up of the edges of the members of polycrystalline silicon.

In accordance with the present invention, a method for providing a member of polycrystalline silicon semiconductor material on a Si-semiconductor substrate covered by an insulating layer, with a layer of silicon dioxide covering the exposed portions of said member, is characterized by depositing a layer of polycrystalline silicon on said polycrystalline silicon semiconductor material member and on said insulating layer prior to oxidation and thereafter oxidising said layer of polycrystalline silicon and a portion of said member of polycrystalline silicon semiconductor material into said layer of silicon dioxide.

Other features of the present invention are set forth with particularity in the appended claims. The invention itself, both as to its organization and method of operation, together with further objects and advantages thereof, may best be understood by reference to the following description taken in connection with the accompanying drawings wherein:

Figure 1 shows a cross section of a prior art structure formed by prior art methods.

Figures 2A—2C show cross sections of structures representing successive steps in accordance with the method of the present invention.

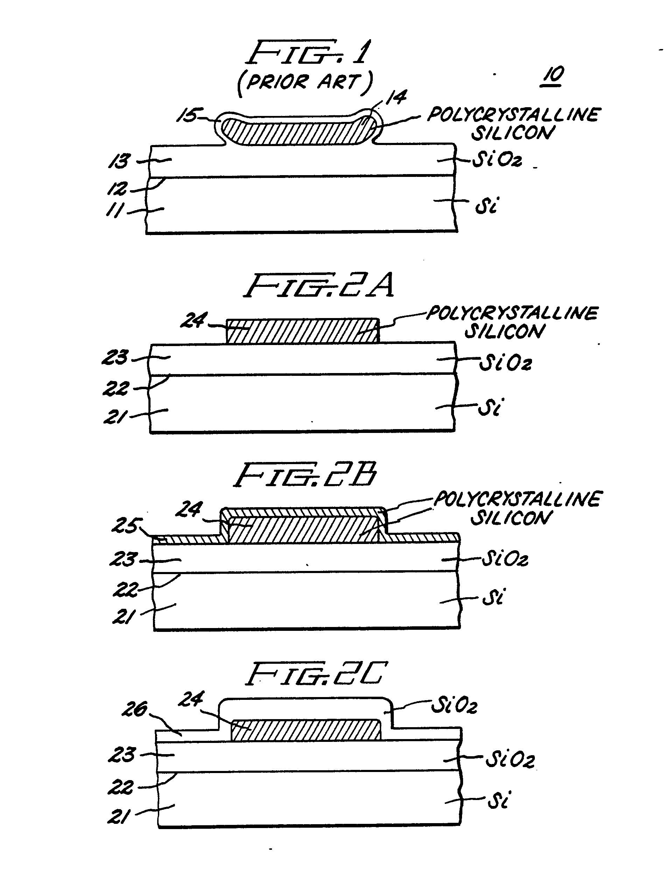

Reference is now made to Figure 1 which shows a cross-sectional view of a prior art structure 10 made by the prior art process. Figure 1 shows a substrate 11 of silicon semiconductor material having a major surface 12 on which was grown a layer of silicon dioxide 13. A layer of polycrystalline silicon 0.65 μm (microns) thick was deposited on the surface of the layer of silicon dioxide, doped to saturation with phosphorus in a conventional process using vapors of phosphorus oxychloride (POCl₃) and patterned by conventional photolithographic masking and etching techniques to form a conductive member 14. Thereafter, the conductive member was thermally oxidized at 900°C in dry oxygen for 20 hours to produce a layer 15 of silicon dioxide thereon approximately 260 nm (2600 Angstroms) thick. In the oxidation process, at the interface between the layer of silicon dioxide and the patterned polysilicon conductor, the deep penetration of oxygen causes oxide formation on the underside of the polycrystalline silicon member and hence produces an uplifting of the edges of the polycrystalline silicon conductor as shown.

Reference is now made to Figures 2A—2C which show various steps in the process for providing a film or coating of silicon dioxide over a member of polycrystalline silicon in accordance with the present invention. Figure 2A shows a substrate 21 of silicon semiconductor material having a major surface 22 parallel to the (100) crystallographic plane of the silicon. A layer 23 of silicon dioxide 1 micron thick was thermally grown on the major surface 22. Thereafter, a layer 24 of polycrystalline semiconductor material was deposited by standard chemical vapor deposition techniques, for example by pyrolytic decomposition of silane, to form a layer of 0.65 μm (microns) thick. The layer of polycrystalline silicon was doped to saturation with phosphorus in a conventional process using phosphorus oxychloride (POCl₃) to lower the resistivity thereof. Thereafter, the polycrystalline silicon layer was patterned using conventional photolithographic masking and etching techniques to form conductors 24. Next, the patterned polycrystalline member 24 was coated with a layer 25 of low pressure chemically vapor deposited polycrystalline silicon 75 nm (750 Angstroms) thick, as shown in Figure 2B. Thereafter, the substrate with the deposited polycrystalline layer was thermally oxidized at 900°C in dry oxygen for 20 hours to oxidize the second layer 25 of polycrystalline silicon into a coating 26 of silicon dioxide, as shown in Figure 2C. In this process, the layer 25 of polycrystalline silicon is completely oxidized and a top portion of the polycrystalline silicon member 24 is oxidized forming a coating over the polycrystalline member 24 approximately 260 nm (2600 Angstroms) thick and over the exposed portions of the layer of silicon dioxide approximately 150 nm (1500 Angstroms) thick with no uplifting of the edges of the polycrystalline silicon member 24.

In order to compare the effectiveness of the process of the present invention with the process in which the overlying layer of polycrystalline silicon is not used, an identical sample of a conductor of polycrystalline silicon on a layer of silicon dioxide was oxidized in the identical way, however, without providing a layer of polycrystalline silicon over the polycrystalline silicon member. In this case, thermal oxidation was performed at 900°C. in dry oxygen for 20 hours, and resulted in a coating of dioxide 260 nm (2600 Angstroms) thick in the patterned polycrystalline silicon member 24. An edge uplift of approximately 200 nm (2000 Angstroms) was observed. In applicants' process no edge uplift was observed.

A feature of the present invention is that layer 25 of polycrystalline silicon is deposited undoped but yet picks up phosphorus from doped polycrystalline silicon member 24 to form a layer 26 of silicon dioxide 260 nm (2600 Angstroms) thick on the member 24. Normal undoped polycrystalline silicon would grow 147 nm (1470 Angstroms) of oxide during this oxidation time. Thus, the process of the present invention is not only useful in eliminating edge lift up but also at the same time produces a thicker overlying layer of silicon dioxide as desired in integrated circuit devices.

While, in the example described above, the polycrystalline silicon member was formed on an insulating layer of silicon dioxide, it will be understood that other insulating layers, such as silicon nitride may be used.

## Claims

1. A method for providing a member (24) of polycrystalline silicon semiconductor material on a Si-semiconductor substrate (21) covered by an insulating layer (23), with a layer (26) of silicon dioxide covering the exposed portions of said member (24), characterized by depositing a layer (25) of polycrystalline silicon on said polycrystalline silicon semiconductor material member (24) and on said insulating layer (23) prior to oxidation and thereafter oxidising said layer (25) of polycrystalline silicon and a portion of said member (24) of polycrystalline silicon semiconductor material into said layer (26) of silicon dioxide.

2. The method of claim 1 in which said insulating layer (23) is silicon dioxide.

3. The method of claim 1 in which said insulating layer is silicon nitride.

4. The method of claim 1 in which the polycrystalline material of said member (24) is doped to provide low resistivity.

5. The method of claim 1 in which said layer (25) of polycrystalline material is formed by chemical vapor deposition.

## Patentansprüche

1. Verfahren zum Schaffen eines Teiles (24) aus polykristallinem Silizium-Halbleitermaterial auf einem Si-Halbleitersubstrat (21), das von einer isolierenden Schicht (23) bedeckt ist, wobei eine Schicht (26) aus Siliziumdioxid, die freigelegten Abschnitte des Teiles (24) bedeckt, gekennzeichnet durch Abscheiden einer Schicht (25) aus polykristallinem Silizium auf dem Teil (24) aus polykristallinem Silizium-Halbleitermaterial und auf der isolierenden Schicht (23) vor der Oxidation und nachfolgend Oxidieren der Schicht (25) aus polykristallinem Silizium und eines Abschnittes des Teiles (24) aus polykristallinem Silizium-Halbleitermaterial zu der Schicht (26) aus Siliziumdioxid.

2. Verfahren nach Anspruch 1, bei dem die isolierende Schicht (23) Siliziumdioxid ist.

3. Verfahren nach Anspruch 1, bei dem die isolierende Schicht Siliziumnitrid ist.

4. Verfahren nach Anspruch 1, bei dem das polykristalline Material des Teiles (24) dotiert ist, um einen geringen spezifischen Widerstand zu ergeben.

5. Verfahren nach Anspruch 1, bei dem die Schicht (25) aus polykristallinem Material durch chemische Dampfabscheidung gebildet wird.

## Revendications

1. Procédé pour munir un dispositif (24), en matériau semi-conducteur fait de silicium polycristallin, sur un substrat semi-conducteur de silicium (21) recouvert d'une couche isolante (23), d'une couche (26) de dioxyde de silicium recouvrant les portions apparentes dudit dispositif (24), caractérisé par le dépôt d'une couche (25) de silicium polycristallin sur ledit dispositif en matériau semi-conducteur fait de silicium polycristallin (24) et sur ladite couche isolante (23) avant l'oxydation, puis l'oxydation de ladite couche (25) de silicium polycristallin et d'une portion dudit dispositif (24) en matériau semi-conducteur fait de silicium polycristallin en ladite couche (26) de dioxyde de silicium.

2. Procédé selon la revendication 1, dans lequel ladite couche isolante (23) est en dioxyde de silicium.

3. Procédé selon la revendication 1, dans lequel ladite couche isolante est en nitrure de silicium.

4. Procédé selon la revendication 1, dans lequel le matériau polycristallin dudit dispositif (24) est dopé pour conférer une faible résistivité.

5. Procédé selon la revendication 1, dans lequel ladite couche (25) de matériau polycristallin est formée par dépôt par vaporisation chimique.

## FIG. 1
### (PRIOR ART)

<u>10</u>

15    14
POLYCRYSTALLINE
SILICON

13    SiO2

12
11    Si

## FIG. 2A

24    POLYCRYSTALLINE
SILICON

23    SiO2

22
21    Si

## FIG. 2B

24    POLYCRYSTALLINE
SILICON

25
23    SiO2

22
21    Si

## FIG. 2C

26    24    SiO2

23    SiO2

22
21    Si

1